# EUROPEAN PATENT APPLICATION

(11) **EP 0 539 233 A1**
(43) Date of publication of application: **28.04.1993**
(21) Application number: 92309758.8
(22) Date of filing: 23.10.1992
(51) Int. Cl.: H01L 21/3205, H01L 21/321

(54) **Method of manufacturing semiconductor device**

(30) Priority: 25.10.1991 JP 279540/91
(71) Applicant: NEC CORPORATION, Tokyo (JP)
(72) Inventor: Zenke, Masanobu, Minato-ku, Tokyo (JP)
(74) Representative: Abnett, Richard Charles

(57) **Abstract**

A method of manufacturing a semiconductor device includes the steps of forming a lower electrode (3) on a semiconductor substrate (1), subjecting the lower electrode to a rapid heat-treatment to eliminate moisture from the lower electrode surface, and forming a capacitative insulating film (5) consisting of a metal oxide film on the lower electrode. The heat treatment may be conducted in at least an ammoniac atmosphere to form a nitrided layer (11) on the surface of the lower electrode (3).

## Description

### BACKGROUND OF THE INVENTION

### 1. Field of the invention:

This invention relates to a method of manufacturing a semiconductor device, and more particularly to a method of manufacturing a capacitor part of the semiconductor device.

### 2. Description of the Prior Art:

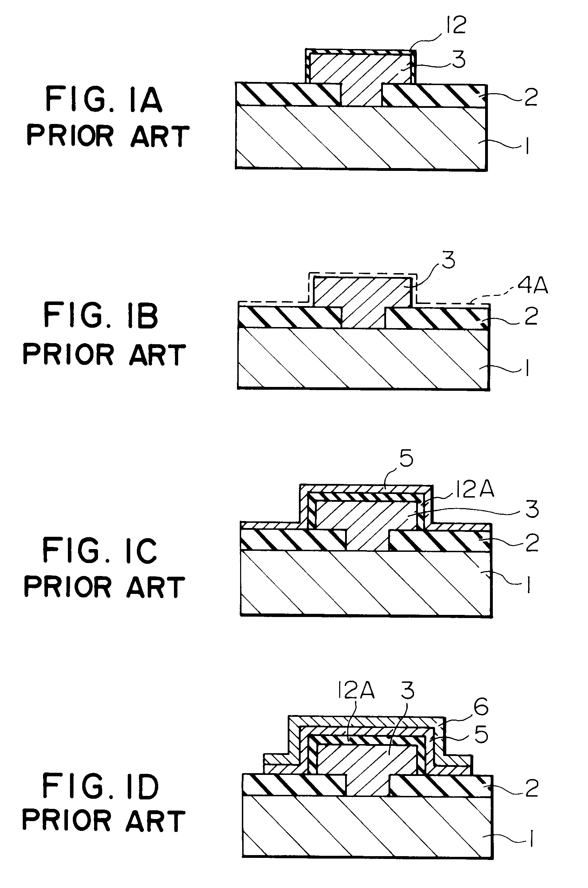

A prior art method of manufacturing a capacitor part of a semiconductor device using a metal oxide film as a capacitive insulating film will be described below with reference to Figs. 1A to 1D.

As shown in Fig. 1A, a silicon oxide film 2 is first formed on a silicon substrate 1, and then subjected to a patterning process to form an aperture therein. Subsequently, a lower electrode 3 comprised of a polycrystalline silicon film is formed on the film 2. At the same time, another silicon oxide film 12 is formed on the surface of the lower electrode 3. Next, as shown in Fig. 1B, the silicon oxide film 12 is removed by immersing it in an aqueous solution containing hydrofluoric acid (HF).

In the next place, as shown in Fig. 1C, Ta₂O₂ film 5 is caused to grow by chemical vapor deposition (CVD) process using Ta(OC₂H₂)₂, TaCl, etc. as raw materials. After that, as shown in Fig. 1D, an upper electrode 6 comprised of tungsten is formed on the film 5, thus completing the capacitor part.

According to this prior art method of manufacturing a capacitor part of semiconductor device, since the silicon oxide film 12 formed on the lower electrode 3 comprised of a polycrystalline silicon film is removed by immersing a semiconductor chip in an aqueous solution containing hydrofluoric acid before the formation of a metal oxide film 5 as a capacitive insulating film, and then the semiconductor chip is washed by water, moisture 4A is attached to the surface of the chip as shown in Fig. 1B. And, in case Ta₂O₅ is formed as a metal oxide film by CVD process or the like, moisture is eliminated from the surface of the semiconductor chip, and oxidizes the surface of the lower electrode 3 comprised of a polycrystalline silicon film or the like before the growth of the metal oxide film 5. In addition, in the early stages of the conventional CVD process, the surface of the chip is oxidized by oxygen existing in an oxygenic atmosphere for the CVD process. As a result, a silicon oxide film 12A which serves as a capacitive insulating film is formed on the surface of the lower electrode 3 (Fig. 1C), thus posing a problem wherein a capacitive part having a high capacitive can not be produced readly.

### SUMMARY OF THE INVENTION

According to the present invention, there is provided a method of manufacturing a semiconductor device, comprising the steps of forming a lower electrode on a semiconductor substrate, subjecting the lower electrode to a rapid heat treatment using a rapid heating device, and then forming a capacitive insulating film comprised of a metal oxide film on the lower electrode.

Further, according to one exemplified feature of the present invention, there is provided a method of manufacturing a semiconductor device wherein the rapid heat-treatment is conducted in at least ammonic atmosphere.

According to the above mentioned method of manufacturing a semiconductor device, an effect of restraining the formation of the silicon oxide film which is formed between the lower electrode and the metal oxide film as a capacitive insulating film by oxygen existing in an oxygenic atmosphere of the conventional CVD process at the early stages thereof and moisture attached by water-washing of the semiconductor chip to the surface thereof is obtained by subjecting the semiconductor chip to a rapid heat-treatment before the formation of the metal oxide film, thereby eliminating the moisture attached to the surface of the semiconductor chip. The surface of the lower electrode may then also be nitrided. Consequently, the thickness of the capacitive insulating film can be made thinner than those obtained by the prior art method of manufacturing a semiconductor device with the result that a semiconductor device having a capacitor part which has a high capacitance is obtained.

The above and many other advantages, features and additonal objects of the present invention will become apparent to those skilled in the art by making reference to the following detailed description and accompanying drawings in which preferred embodiments incorporating the principles of the present invention are shown by way of example only.

### BRIEF DESCRIPTION OF THE DRAWINGS

Fig. 1A to 1D are schematic sectional views of a semiconductor chip for explaining a prior art method of manufacturing a semiconductor;
Fig. 2A to 2D are schematic sectional views of a semiconductor chip for explaining a method of manufacturing a semiconductor device according to the present invention;
Fig. 3 is a schematic sectional view of a lamp annealing apparatus for use in the method of manufacturing a semiconductor device according to the present invention;
Fig. 4 is a graph showing a sequence for use in the method of manufacturing a semiconductor device according to the present invention;
Fig. 5 is a graph showing a sequence for use in another method of manufacturing a semiconductor device according to the present invention; and
Fig. 6 is a graph showing the relationship between the thickness of Ta₂O₅ film and the converted thickness of the oxide film.

### DETAILED DESCRIPTION OF THE PREFERRED EMBODIMENT

The present invention will now be described below with reference to the accompanying drawings.

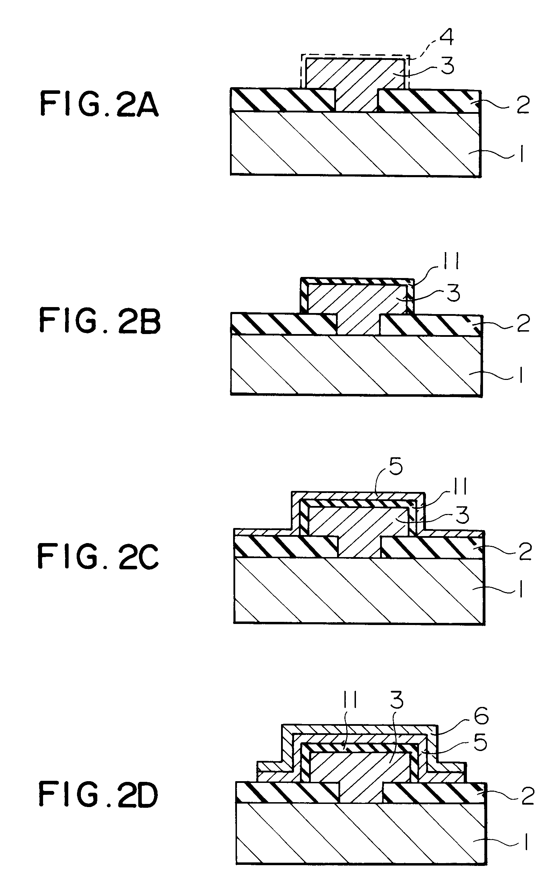

Figs. 2A to 2D are sectional views of a stack type capacitor part for explaining a first embodiment of the present invention.

As shown in Fig. 2A, a silicon oxide film 2 having an aperture is first formed on a silicon substrate 1, and then a lower electrode 3 comprised of a polycrystalline silicon film is formed on the film 2. This lower electrode 3 has a small amount of moisture 4 attached to the surface thereof.

Next, as shown in Fig. 2B, the silicon substrate 1 is heated rapidly by means of a lamp annealing device in an ammonic (NH₃) atmosphere so as to eliminate the moisture 4 on the polycrystalline silicon film 3 and nitride the surface of the film 3 to thereby form a silicon nitride film 11, about 1 nm thick.

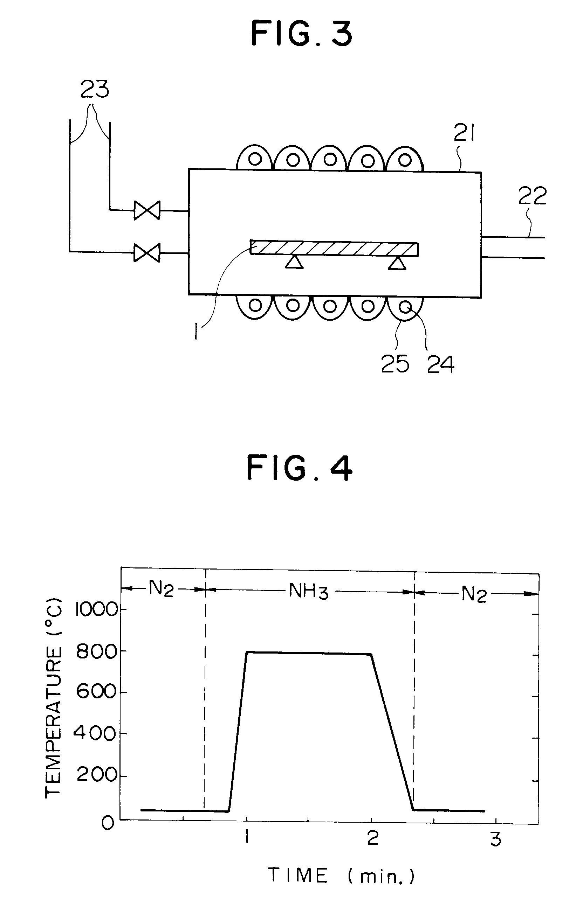

As shown in Fig. 3, the lamp annealing device is mainly constituted by a crucible body 21 provided with exhaust pipes 22 and gas inlet pipes 23, and lamps 24 and a reflector plate 25 mounted around the crucible body 21, and a silicon substrate 1 is set in the crucible. As the conditions for the rapid heat-treatment in case the sequence as shown in Fig. 4 is used, the heating speed is 50 to 200 °C /sec, and the heat-treatment temperature is the range of 800 to 1,000 °C , for example.

In the next place, as shown in Fig. 2C, Ta₂O₅, 8 to 30 nm thick, is formed by chemical vapor deposition process as a capacitive insulating film 5 on the silicon nitride film 11. As the conditions for growing Ta₂O₅ film, for example, Ta(OC₂H₅)₅ and O₂ are used at temperatures ranging from 400 to 700 °C, or TaCl₅ and N₂O are used attemperatures ranging from 700 to 1,000°C. The pressure applicable at that time is in the range of 0.1 to 1 torr.

Subsequently, as shown in Fig. 2D, a layer of high-melting point metal such as, for example, tungsten (W) is formed by sputtering process or CVD process on the Ta₂O₅ film, and then subjected to patterning process so as to form an upper electrode 6, thus completing the capacitor part of the semiconductor device.

As mentioned hereabove, in the first embodiment, since after the formation of the lower electrode 3, the latter is subjected to a rapid heat-treatment in an ammonic atmosphere so as to eliminate the moisture attached to the surface of the lower electrode 3 comprised of a polycrystalline silicon film, and nitride the surface of the lower electrode 3, it becomes possible to prevent the polycrystalline silicon film from being oxidized by oxygen in the early stage of the conventional CVD process and the moisture on the surface thereof in the course of growing a metal oxide film such as Ta₂O₅, etc. by vapor phase growth process. Therefore, because the oxide film is not formed between the metal oxide film 5 serving as a capacitive insulating film and the lower electrode 3, a capacitor part having a high capacitance is obtained.

Further, the reason for the use of the lamp annealing device is that since the wafers placed on the flat surface of a conveyor at the regular intervals are continuously heat-treated with a high moisture purging effect in a short time, the growth of natural oxide film can be restrained, in contrast to a CVD device or a diffusion crucible wherein putting-in and -out of semiconductor substrate takes a considerable period of time during which the nutral oxide film is liable to grow.

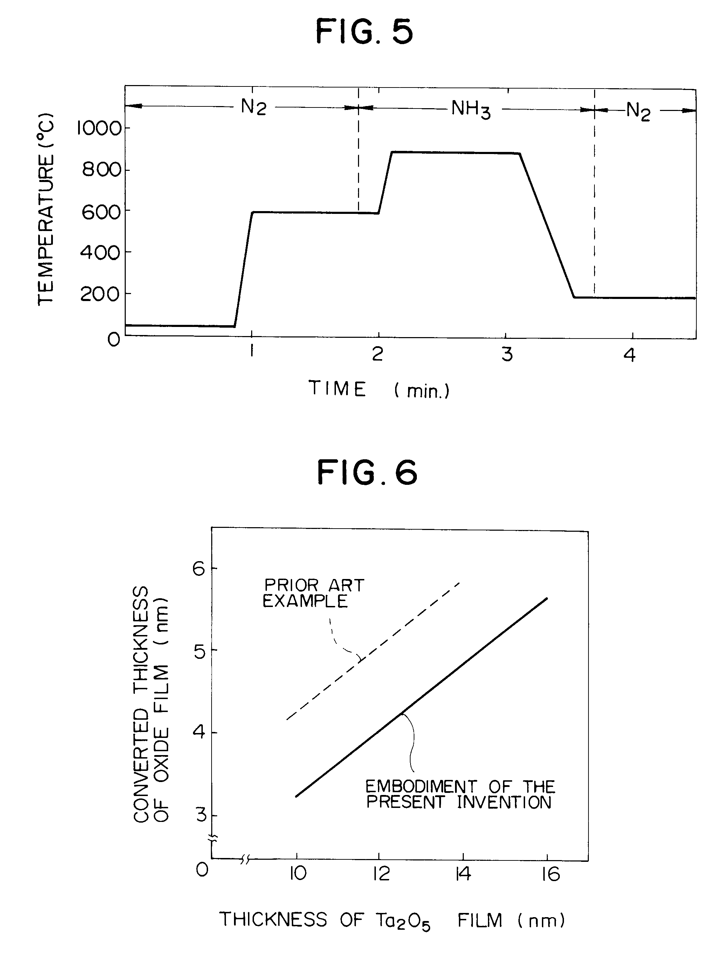

Thus, according to the first embodiment, as can be seen from the graph shown in Fig. 6, the converted or reduced thickness of the oxide film such as Ta₂O₅ can be made thinner by about 1 nm than those obtained by the prior art eample, and therefore a capacitor part having a high capacitance is obtained.

Fig. 5 shows a sequence for rapid heat-treatment using the lamp annealing device for explaining the second embodiment of the present invention.

While, in the first embodiment the rapid heating was made at temperature from 800 to 1,100 °C in an ammonic atmosphere as shown in Fig. 4, in the second embodiment, a rapid heat-treatment was made at temperatures from 400 to 700 °C in N₂ atmosphere, and then another rapid heat-treatment was conducted at temperatures from 800 to 1,000 °C in NH₃ atmosphere, thereby nitriding the surface of the polycrystalline silicon film forming the lower electrode to form a silicon nitride film, about 1 to 3 nm thick.

The reason for the performance of the heat-treatment of semiconductor chip in the two stages (in the N₂ and NH₃ atmospheres, respectively,) is as follows. In the case of the first embodiment wherein the wafer is nitrided by the first stage heat-treatment for heating it rapidly to a high temperature, there is a possiblity of a very small amount of moisture contained in the wafer or in the NH₃ atmospher being attached to the surface of the polycrystalline silicon film to a depth of 1 to 3 nm. In the second embodiment the oxidation of the polycrystalline silicon film caused by the existence of oxygen in the early stages of the conventional CVD process and moisture on the polycrystalline silicon film can be eliminated.

While, in the first and second embodiments, the description has been made in respect to the case where the polycrystalline silicon film is used as the lower electrode, the present invention is not limited thereto, a high-meltingpoint metal such as W, Mo, etc., a metal nitride such as titanium nitride, etc., or a metal silicide such as tungstensilicide, etc. may be used as the lower electrode. In thesecases too, the oxidation of the polycrystalline silicon film by the moisture during the metal oxide film forming step canbe restrained. Further, the present invention is also applicable to the case where another metal oxide film than Ta₂O₅ such as, for example, HfO₂ can be used as the capacitive insulating film.

It is to be understood that the foregoing description is merely illustrative of preferred embodiments of the invention, and that the scope of the invention is not to be limited thereto, but is to be determined by the scope of the appended claims.

## Claims

1. A method of manufacturing a semiconductor device, comprising the steps of: forming a lower electrode on a semiconductor substrate; subjecting the lower electrode to a rapid heat-treatment; and then forming a capacitive insulating film comprised of a metal oxide film on said lower electrode.

2. A method of manufacturing a semiconductor device as claimed in claim 1, wherein said rapid heat-treatment is conducted in at least ammonic atmosphere.
